# EUROPEAN PATENT APPLICATION

(11) **EP 1 720 167 A2**
(43) Date of publication of application: **08.11.2006**
(21) Application number: 06250190.3
(22) Date of filing: 13.01.2006
(51) Int. Cl.: G11B 33/12

(54) **Data line switching circuit for optical pickup device**

(30) Priority: 07.05.2005 KR 2005011094
(71) Applicant: Samsung Electronics Co., Ltd., Suwon-si Gyeonggi-do (KR)
(72) Inventor: Kim, Jong-uk, Giheung-eup, Yongin-si,Gyeonggi-do (KR); Yoo, Jang-hoon, Sinjeong 1-dong, Yangcheon-gu (KR); Jang, Hag-hyeon, dong, Bundang-gu,Seongnam-si Gyeonggi-do (KR); Jeon, Young-sun, Macheon2-dong Songpa-gu (KR); Kim, Hyung-jin, Jung-gu (KR)
(74) Representative: Brandon, Paul Laurence

(57) **Abstract**

A data line switching circuit of an optical pickup device is disclosed. In order to drive multiple formats of optical disks, the data line switching circuit applies data signals of a corresponding format to the optical pickup device through a common connector by connecting data lines of the corresponding format to the common connector according to control signals from a control unit (16), thereby minimizing the number of terminals of the connector to obtain a miniaturized optical pickup device.

## Description

The present invention relates to data line switching circuit optical pickup devices. Generally, an optical disk recording/reproducing device for recording/reproducing a compact disk (CD), a digital video disk (DVD), and the like, records or reproduces data by irradiating laser beams on a recording surface.

Therefore, the optical disk recording/reproducing device is provided with an optical pickup device and a servo system. The optical pickup device optically accesses an optical disk, and the servo system allows the optical pickup device to access a particular track.

The optical pickup device typically includes a laser diode used as a light source, a photodiode used as an optical detection device, an object lens for focusing light beams emitted from the laser diode on an optical disk in the form of a fine spot, and an optical system for guiding the light beams emitted from the laser diode to the object lens and light reflected from the optical disk to the photodiode. The optical pickup device further includes an actuator that drives the object lens in a focusing direction and a tracking direction under the control of a focus servo system and a tracking servo system.

The servo system includes a tracking servo, a focusing servo, a spindle servo, and a sled servo.

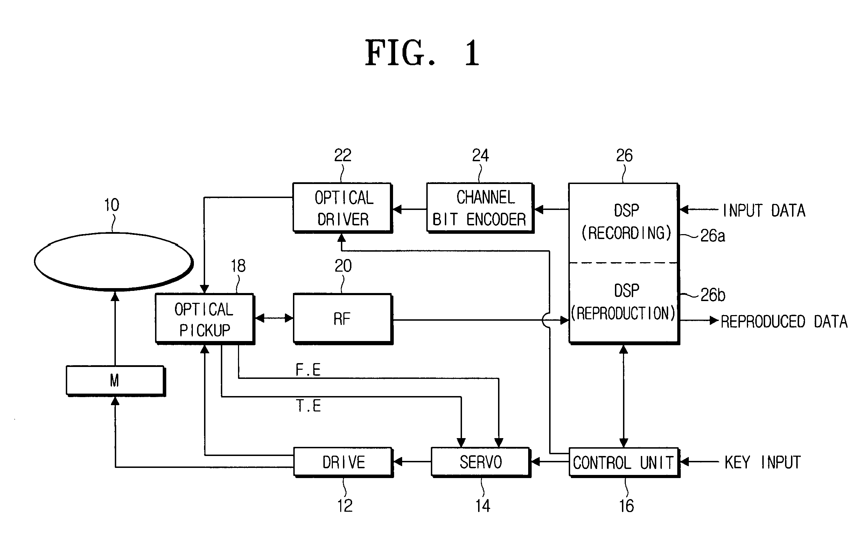

FIG. 1 illustrates a conventional optical disk recording/reproducing device.

As shown in FIG. 1, the optical disk recording/reproducing device includes a digital signal processor (DSP) 26a converting externally input digital data into a recording format by adding an error correction code (EEC) thereto, a channel bit encoder 24 for reconverting the data converted into the recording format into bit streams, an optical driver 22 for outputting a light drive signal according to an input signal, an optical pickup 18 for recording the input signal on an optical disk 10 according to the light drive signal and detecting a recording signal from a recording surface, an R/F unit 20 for filtering the signal detected from the optical pickup 18 to output a binary signal, a drive unit 12 for driving a spindle motor M that rotatably drives the optical pickup 18 and the optical disk 10, a servo 14 for receiving a tracking error (TE) signal and a focusing error (FE) signal of the optical pickup 18 and a rotational speed of the optical disk 10 to control driving of the drive unit 12, a digital signal processor (DSP) 26b for restoring the binary signal to the original data using a clock phase-synchronized with the binary signal output from the R/F unit 20, and a control unit 16 for generating a sector address where data is to be recorded and various disk management data while controlling the whole system, and controlling the system to allow the disk management data to be recorded in a predetermined area on the disk after recording.

In the mechanism of the aforementioned optical disk recording/reproducing device, a mechanism base is fixed to a main printed circuit board (hereinafter referred to as a "main board") provided with a driving circuit. A sled base that supports the spindle motor for rotating the optical pickup device and the optical disk is rotatably mounted to the mechanism base.

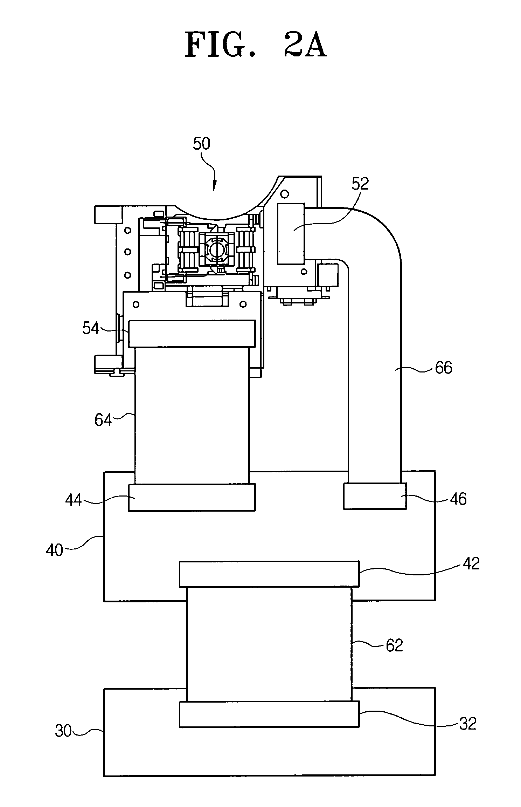

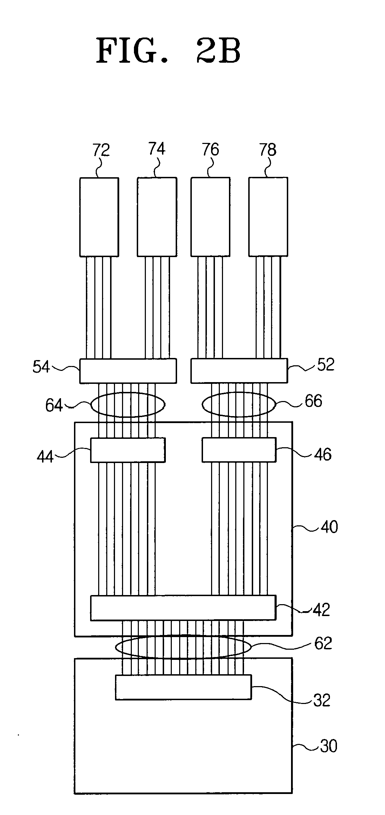

FIG. 2A illustrates the state that the mechanism base is fixed to the main board. Especially, FIG. 2A illustrates a multi disk recording/reproducing device that can reproduce Blu-Ray disk (BD), advanced optical format (AOD), DVD, CD, and so on. FIG. 2B illustrates signal lines connected to connectors.

As shown, a mechanism base 50 is electrically connected with a main board 30 through a cable so that it can optically access the optical disk in response to an electrical signal supplied from the main board 30 and transmit a signal read from the optical disk to the main board 30. Flexible printed circuit boards (FPCBs) are generally used as the cable connecting the mechanism base 50 and the main board 30. FPCBs are formed by coating a copper clad pattern on a main film. The cable can be manufactured according to user's desired shape. As shown, the respective FPCBs are connected to one another through a connector.

In more detail, control and data signals for driving the disks on the main board 30 are connected to a first connector 42 of a connection board 40 through a connector 32 and a first FPCB 62.

Respective signal lines connected to the first connector 42 are grouped into control and data signals for CD and AOD and connected to a second connector 44. The respective signal lines are also grouped into control and data signals for DVD and BD and connected to a third connector 46 (see FIG. 2B).

The control and data signals for CD and AOD are connected to a fourth connector 54 of the mechanism base 50 through a second FPCB 64 connected to the second connector 44 so that the signals are supplied to the fourth connector 54.

Also, the control and data signals for DVD and BD are connected to a fifth connector 52 of the mechanism base 50 through a third FPCB 66 connected to the third connector 46 so that the signals are supplied to the fifth connector 52.

Meanwhile, the control and data signals for CD and AOD connected to the fourth connector 54 are respectively divided into control and data signals 72 for CD and control and data signals 74 for AOD. The control and data signals for DVD and BD connected to the fifth connector 56 are respectively divided into control and data signals 76 for DVD and control and data signals 78 for BD.

As described above, in the conventional optical disk recording/reproducing device, a connector having terminals that can be connected to a number of signal lines is required to drive a compatible optical pickup device such as BD, AOD, DVD and CD. Generally, terminals of 100 pins or greater are required to be compatible with BD, AOD, DVD, and CD.

Therefore, since a large number of connectors are used to connect the signal lines, a space occupied by the connectors becomes great. This could lead to difficulty in making a slim sized optical pickup device. Accordingly, there is a desire for a device to minimize the number of terminals connected to an optical pickup device.

An aim of preferred embodiments of the present invention is to provide a switching circuit that can minimize the number of terminals of an optical pickup device.

The present invention provides a data line switching circuit of an optical pickup device that drives multiple optical disk formats, including a switching unit for selectively outputting data signals of the optical pickup device of the different formats, a control unit for outputting control signals by disks to control the switching unit, and a common terminal for supplying the output signals of the switching unit to the optical pickup device, wherein the control unit controls the switching unit to be in an on/off state according to the formats so that the data signal of the corresponding format is applied to the optical pickup device through the common terminal.

Suitably, the switching unit includes a first connector connected to the respective control signals and data signals required to drive the multiple disk formats, and latches, electrically connected to the first connector, for selecting the data signals by disks from the signals of the first connector according to the control signals by disks from the control unit to output the selected signals.

Preferably, the data line switching circuit further includes a decoder for outputting signals to select the data signals of the corresponding disks according to the control signals by disks from the control unit, wherein the latches select the data signals by disks from the signals of the first connector according to the output signals of the decoder to output the selected data signals.

Suitably, the switching unit, the control unit and the common terminal are provided on one board to obtain a slim optical pickup device.

Suitably, the switching unit includes a first connector connected to the respective control signals and data signals required to drive the multiple formats of disks, a plurality of latches, electrically connected to the first connector, for receiving the signals of the first connector as data signals by disks and selectively outputting the data signals of the corresponding disks according to the control signals by disks from the control unit, and a first data connector, electrically connected to the common terminal, for commonly receiving and connecting the data signal lines from the plurality of latches with the common terminal.

Suitably, the data line switching device further includes a decoder for outputting signals to select the corresponding latches according to the control signals by disks from the control unit, wherein the data signals of the corresponding latches selected by the output signals of the decoder are output to the first data connector.

Preferably, the control unit outputs the different control signals according to types of disks including a BD, AOD, DVD and CD.

More preferably, the common terminal applies the data signal of the corresponding format output from the switching unit and the control signals for driving the multiple formats of disks to the optical pickup device.

The present invention will be more apparent by describing certain embodiments of the present invention, by way of example only, with reference to the accompanying drawings, in which:
FIG. 1 illustrates a conventional optical disk recording/reproducing device;
FIG. 2A illustrates a mechanism base fixed to a main board in a conventional device;
FIG. 2B illustrates signal lines connected to connectors in a conventional device;
FIG. 3A illustrates an optical disk recording/reproducing device in accordance with an embodiment of the present invention;
FIG. 3B illustrates signal lines connected to connectors in accordance with an embodiment of the present invention; and
FIG. 4 illustrates the detailed structure of a switching circuit according to an embodiment of the present invention.

Throughout the drawings, like reference numbers will be understood to refer to like elements, features, and structures.

Exemplary embodiments of the present invention will now be described in detail with reference to the annexed drawings. In the following description, detailed descriptions of known functions and configurations incorporated herein have been omitted for conciseness and clarity.

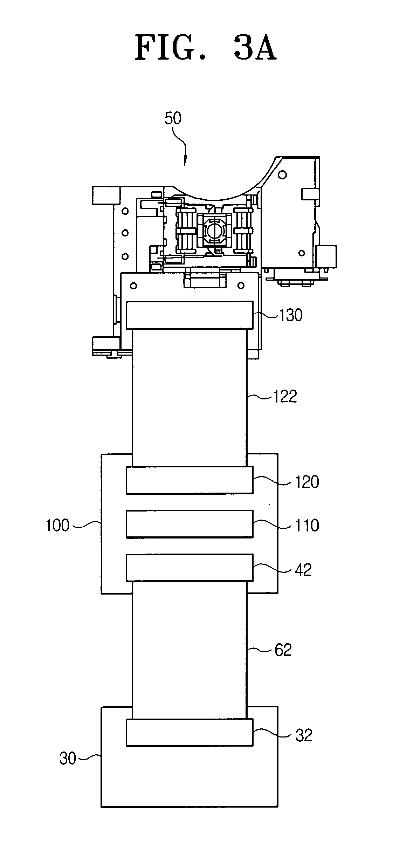

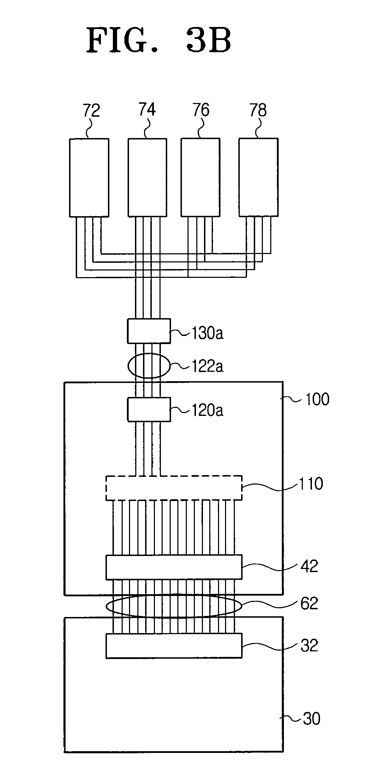

FIG. 3A illustrates an optical disk recording/reproducing device in accordance with an embodiment of the present invention, and FIG. 3B illustrates signal lines electrically connected to connectors in accordance with an embodiment of the present invention.

Since the same drawing reference numerals are used for the same elements as those of the related art, their description will be omitted for clarity and conciseness.

Therefore, elements according to an embodiment of the present invention, that is, a control unit 16, a switching unit 110, a first common connector 120, and a second common connector 130 will be described. The first common connector 120 connects each terminal signal of the switching unit 110 to a common terminal. The second common connector 130 connects signals to a mechanism base 50 through a common connection FPCB 122.

The control unit 16 outputs control signals as indicated below through control lines Control_A and Control_B after determining the type of a disk to be reproduced or recorded in a multiple format optical disk recording/reproducing device.

**[Table 1]**

| Control_A | Control_B | First Latch | Second Latch | Third Latch | Fourth Latch |
|---|---|---|---|---|---|
| 0 | 0 | ON | OFF | OFF | OFF |
| 1 | 1 | OFF | ON | OFF | OFF |
| 0 | 0 | OFF | OFF | ON | OFF |
| 1 | 1 | OFF | OFF | OFF | ON |

Table 1 shows that corresponding latches are controlled to be in an on/off state according to the signal combination of signals Control_A and Control_B.

The switching unit 110 is provided with data lines from signals connected from the main board 30 to the first connector 42 through the connector 32 including the control and data signals required to drive the multiple formats of disks and the first FPCB 62 to select a data line corresponding to a specific type of disk and transmit the selected data line through the first common terminal 120.

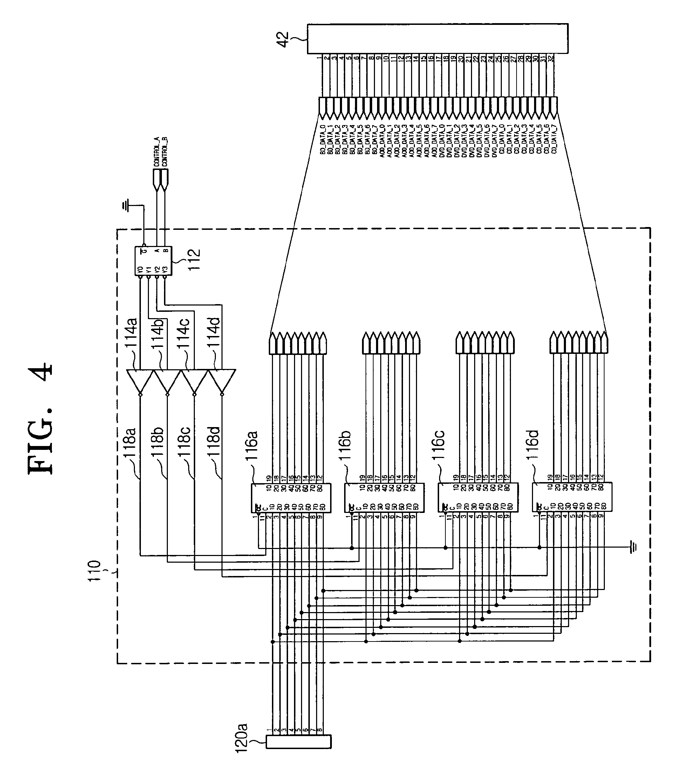

Hereinafter, the switching unit 110 will be described in detail with reference to FIG. 4.

The switching unit 110 is provided in the connection board 100 and includes a first connector 42 connected with each data signal of 8 bits required to drive the multiple disk formats, first to fourth latches 116a, 116b, 116c and 116d supplied with the signals of the first connector 42 through a data line of each type of disk so as to be in an on/off state, two-to-four line decoder 112 for controlling the on/off operations of the first to fourth latches 116a to 116d according to control signals by types of disks from the control unit 16, a plurality of inverters 114a to 114d , and a first data connector 120a commonly supplied with eight data signals output from the latches 116a to 116d and connected to the first common connector 120 that is a common terminal.

The line decoder 112 is constructed to output control signals 118a, 118b, 118c and 118d that will control the on/off operations of the latches 116a, 116b, 116c and 116d according to the data applied through the control lines Control_A and Control_B of the control unit 16. Their detailed operation is as shown in Table 1.

The first latch 116a is provided with a data line of a corresponding disk type from the first connector 42 connected with each data signal of 8 bits required to drive the multiple formats of the disks, and is operated by a switching integrated circuit (IC) that controls the on/off operation of an output signal of the data line according to the control signal 118a of the decoder 112. The latch is used to continuously maintain the output state.

Likewise, the second to fourth latches 116b, 116c and 116d are constructed to control the on/off operation of an output signal of a corresponding data line according to the respective control signals 118b, 118c and 118d.

In embodiments of the present invention, the output signals of the decoder 112 are respectively applied to the latches 116a to 116d after their logics are changed using the inverters 114a, 114b, 114c and 114d.

The data output lines of the first to fourth latches 116a to 116d are commonly connected to the first data connector 120a to be connected to the data lines of 8 bits.

As described above, the data lines of 8 bits according to the specific type of disk are connected to the second data connector 130a provided in the mechanism base 50 and the data connection FPCB 122a through the first data connector 120a and then respectively divided into the control and data signals 72 for CD, the control and data signals 74 for AOD, the control and data signals 76 for DVD, and the control and data signals 78 for BD.

In the embodiments of the present invention described herein, the data lines selected and output from the switching unit 110 of the connection board 100 are connected to the first data connector 120a, the data connection FPCB 122a and the second data connector 130a. However, the first data connector 120a, the second data connector 130a and the FPCB 122a are respectively included in the first common connector 120, the common connection FCB 122, and the second common connector 130.

Therefore, since the conventional second connector 44, the third connector 46, the fourth connector 54, the fifth connector 52, the second FPCB 64, and the third FPCB 66 can be replaced with the first common connector 120, the common connection FPCB 122, and the second common connector 130, a slim volume can be achieved.

Furthermore, in the embodiments of the present invention described herein, data are connected only in a specific direction. However, the data may bidirectionally be transmitted and received according to a reproducing mode and a recording mode.

As described above, the data line switching circuit of the optical pickup device according to an embodiment of the present invention is suitable to obtain the slim size of the optical pickup device because a connector having a small number of terminals can be used.

The foregoing embodiment and advantages are merely exemplary and are not to be construed as limiting the present invention. The present teaching can be readily applied to other types of apparatuses. Also, the description of the embodiments of the present invention is intended to be illustrative, and not to limit the scope of the claims, and many alternatives, modifications, and variations will be apparent to those skilled in the art.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A data line switching circuit of an optical pickup device that drives optical disks of multiple formats, the data line switching circuit comprising:
a switching unit (110) for selectively outputting data signals of the optical pickup device of the different formats;
a control unit (16) for outputting control signals by disk format to control the switching unit; and
a common terminal (120) for supplying the output signals of the switching unit to the optical pickup device;
wherein the control unit controls the switching unit to be in an on/off state according to the disk formats so that the data signal of the corresponding format is applied to the optical pickup device through the common terminal.

2. The data line switching circuit of an optical pickup device as claimed in claim 1, wherein the switching unit (110) comprises:
a first connector (142) connected to the respective control signals and data signals required to drive the multiple disk formats; and
latches (116a, 116b, 116c, 116d), electrically connected to the first connector, for selecting the data signals according to disk format from the signals of the first connector according to the control signals by disk format from the control unit to output the selected data signals.

3. The data line switching circuit of an optical pickup device as claimed in claim 2, further comprising a decoder (112) for outputting signals to select the data signal of the corresponding disk format according to the control signals by disk format from the control unit (16);
wherein the latches (116a, 116b, 116c, 116d) select the data signals by disk format from the signals of the first connector (42) according to the output signals of the decoder to output the selected data signals.

4. The data line switching circuit of an optical pickup device as claimed in claim 2 or claim 3, wherein the switching unit (110) and the common terminal (120) are provided on one board.

5. The data line switching circuit of an optical pickup device as claimed in claim 4, wherein the control unit (16) is included on the board.

6. The data line switching circuit of an optical pickup device as claimed in claim 1, wherein the switching unit (16) comprises:
a first connector (42) connected with the respective control signals and data signals required to drive the multiple formats of disks;
a plurality of latches (116a, 116b, 116c, 116d), electrically connected to the first connector, for receiving the signals of the first connector as data signals by disk format and selectively outputting the data signals of the corresponding disks according to the control signals by disk format from the control unit; and
a first data connector (120a), electrically connected to the common terminal, for commonly receiving and connecting the data signal lines from the plurality of latches with the common terminal.

7. The data line switching circuit of an optical pickup device as claimed in claim 6, further comprising a decoder (112) outputting signals to select the corresponding latches (116a, 116b, 116c, 116d) according to the control signals by disk format from the control unit (16);
wherein the data signals of the corresponding latches selected by the output signals of the decoder are output to the first data connector (120a).

8. The data line switching circuit of an optical pickup device as claimed in any preceding claim, wherein the control unit (16) outputs the different control signals according to types of disks including a BD, AOD, DVD and CD.

9. The data line switching circuit of an optical pickup device as claimed in any preceding claim, wherein the common terminal (120) applies the data signal of the corresponding format output from the switching unit (110) and the control signals for driving the multiple formats of disks to the optical pickup device.
